Europäisches Patentamt

European Patent Office

Office européen des brevets

(19)

(11) Veröffentlichungsnummer : **0 020 866**
**B1**

# (12) EUROPÄISCHE PATENTSCHRIFT

(45) Veröffentlichungstag der Patentschrift :
**11.05.83**

(51) Int. Cl.³ : **H 05 K   7/18**

(21) Anmeldenummer : **80101418.4**

(22) Anmeldetag : **18.03.80**

(54) **Tragbares Koffergerät zur Prüfung von Datenfernverarbeitungssystemen.**

(30) Priorität : **18.06.79 DEU 7917450**

(43) Veröffentlichungstag der Anmeldung :
**07.01.81 Patentblatt 81/01**

(45) Bekanntmachung des Hinweises auf die Patenterteilung : **11.05.83 Patentblatt 83/19**

(84) Benannte Vertragsstaaten :
**AT BE CH FR IT LU NL SE**

(56) Entgegenhaltungen :
**DE A 2 806 284**
**DE B 2 620 758**
**DE U 7 833 283**
**US A 4 149 218**

(73) Patentinhaber : **SIEMENS AKTIENGESELLSCHAFT**
**Berlin und München Wittelsbacherplatz 2**
**D-8000 München 2 (DE)**

(72) Erfinder : **Kerscher, Franz, Ing.-grad.**
**Böcklerweg 13**
**D-8000 München 82 (DE)**
Erfinder : **von Daak, Gerd**
**Tulpenstrasse 71**
**D-8034 Germering (DE)**

Tragbares Koffergerät zur Prüfung von Datenfernverarbeitungssystemen

Die Erfindung betrifft ein tragbares Koffergerät zur Prüfung von Datenfernverarbeitungssystemen gemäß dem Anspruch 1.

Aus dem DE-GM 78 33 283 ist bereits ein tragbares Koffergerät, insbesondere ein Dateneingabe- und -sichtgerät, bekannt, bei dem die Eingabe- und/oder Bedienelemente in einem ersten schwenkbaren Gehäuseteil angeordnet sind und ein zweites Gehäuse an kippbaren Stützen, die mit dem ersten Gehäuseteil verbunden sind, aufgestellt werden kann.

In der DE-AS 26 20 758 wird bereits eine Leiterplattenkassette für großflächige Leiterplatten beschrieben, die in Betriebslage in einem U-förmigen Gehäuserahmen parallel zueinander arretiert und im Fehlerfall ohne Lösen von Steckverbindern für Signal- und Potentialeinschlüsse über Flachband- bzw. Einzelkabel für eine Fehlersuche und/oder Reparatur voll zugänglich sind. Bei dieser Kassette ist jede Leiterplatte mit zwei parallelen Seitenkanten auf Plattenhaltern festgelegt, die paarweise miteinander fluchtende, parallel zur Leiterplatte nach außen ragende Stifte aufweisen. Diese Stife sind als Führungsstifte jeweils nahe an einer der Ecken der Leiterplatte angeordnet.

Sie sind in den parallelen Seitenteilen des Gehäuserahmens in Lagerbohrungen drehbeweglich gelagert bzw. als wahlweise in eine von zwei Raststellungen einrastende Stifte ausgebildet, die in weitere Ausnehmungen der Seitenteile eingreifen. Die Leiterplatte ist dabei aus dem Gehäuserahmen schwenkbar und die Seitenkante einer Leiterplatte nahe der Schwenkachse der Leiterplatte trägt die Steckverbinder zum Zuführen der Signal- und Potentialanschlüsse.

Aufgabe der vorliegenden Erfindung ist es, ein tragbares Koffergerät zur Prüfung von Datenfernverarbeitungssystemen zu schaffen, das den Prüfvorgang erleichtert und für Reparaturarbeiten leicht zugänglich ist.

Zur Lösung dieser Aufgabe wurde gemäß der Erfindung das tragbare Koffergerät derart ausgebildet, daß der zur Prüfung notwendige Logikteil räumlich vom zugehörigen Stromversorgungsteil getrennt ist, daß der Logikteil mit einem Gehäuse versehen, bis zu einem Winkel von etwa 15° gegenüber der Senkrechten mittels einer Kulissenführung ausklappbar und der Stromversorgungsteil fest im Koffer hinter dem eingeklappten Logikteil in einem eigenen Gehäuse, z. B. aus Aluminium, gut wärmeableitend installiert ist.

Durch die konstruktive Trennung des Gerätes in einen separaten Logik- und einen Stromversorgungsteil, ergibt sich nicht nur eine günstigere Verteilung der Verlustleistung des ganzen Gerätes, sondern der logische Teil, in Form eines allseitig schließbaren, HF-dichten Kastens, bietet sich auch als Basis für eine Gerätefamilie an.

Das SV-Gehäuse aus AL, garantiert eine ausreichende Ableitung der Verlustleistung in die Gerätewanne und kann somit den logischen Teil nicht beeinflussen. Außerdem ist die separate Gestaltung der SV günstig für die Zugänglichkeit bei Wartung und für die variable Anordnung von SV-Modulen je nach Leistung der Geräte.

Das 'Herausschwenken des logischen Teiles aus dem Koffer bis auf eine Neigung von 15° ermöglicht die Ausnutzung der natürlichen Konvektion für die Kühlung der Flachbaugruppen sowie wegen der speziellen Anordnung der Flachbaugruppen, eine Prüfung derselben während des Betriebes und ohne Adapter.

Durch zusätzliches Abklappen der Bedienfront und Abnahme der Rückwand ergibt sich eine gute Zugänglichkeit in das Gerät bei Wartungsarbeiten.

Durch das Ausnutzen der Kastenseitenwände für Steckerfelder, wobei auf der linken Seite die Eingänge und auf der rechten Seite die Ausgänge angebracht sein können, ergibt sich eine Betriebsstellung, ohne die kein Netzstecker gesteckt werden kann.

Eine optimale Wartungsstellung ergibt sich, indem rechts und links an den Aufstellstützen je zwei Schrauben gelöst werden, wobei unter Ausnutzung einer weiteren Kulisse im Gehäuse das Gehäuse noch um ca. 30° nach vorne gekippt werden kann. Am Gehäuse des Logikteils 1 ist außerdem eine dritte Kulissenführung 14 angebracht. Zur Befestigung werden die Schrauben 15 soweit gelockert, bis die Rastnase ausklinkt und das Gehäuse in der Kulisse um etwa weitere 30° nach vorne geschwenkt werden kann. Es befindet sich dann in der Wartestellung. Die Begrenzung des Ausschwenkwinkels erfolgt durch die zwei Raststifte 16.

Die Logik-Kassette mit ihren klappbaren Flachbaugruppen ist mittels Flachkabeln über eine Steckerleiste mit dem Bedienfeld verbunden und ist im Bedarfsfall nach Ziehen der Flachkabel leicht austauschbar.

Anhand der Figuren 1 bis 3 wird die Erfindung näher erläutert.

Figur 1 zeigt eine Seitenansicht des Koffergerätes,

Figur 2 zeigt eine Seitenwand des Gehäuses für den Logikteil.

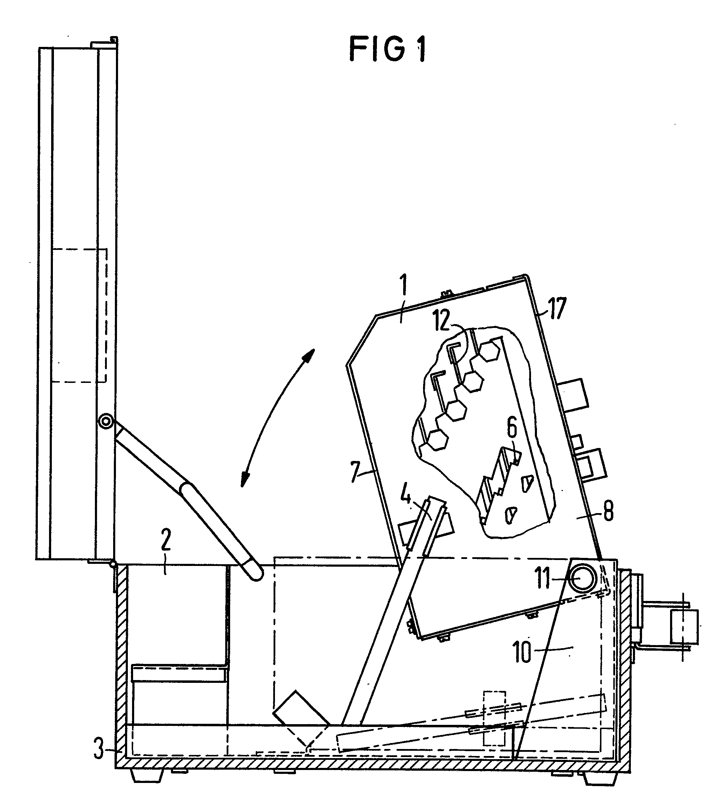

Das Prüfgerät nach Fig. 1 ist in Prüfstellung gezeichnet. Der Koffer 3 ist dabei aufgeklappt und der Logikteil 1 des Prüfgerätes ist aufgeklappt. Dieser Logikteil 1 wird an den beiden Seiten in je einer ersten Kulissenführung 4 geführt, während er an der vorderen Gehäusewandkante mit zwei Schrauben 11 als Drehpunkt ausgeführt und an den Aufstellstützen 10 gelagert ist. Im Inneren des Logikgehäuses sind die Leiterplatten 12 angedeutet, die mit Hilfe einer zweiten Kulissenführung 13 ebenfalls aus dem Gehäuse ausklappbar sind. Die strichlierte Linie zeigt die Begrenzung des Logikteils bei eingeklapptem Zustand. Das Stromversorgungsteil 2 ist hinter dem eingeklappten Logikteil angeordnet, es stellt eine völlig getrennte Baugruppe dar, die so im Koffer plaziert ist, daß eine günstige Wärmeableitung gewährleistet ist. Die geschieht vor allem auch durch ein Gehäuse, das zur besonders guten Wärmeableitung aus Aluminium bestehen kann. Die Leiterplatten 12 sind mit der Bedienfront 17 über steckbare Flachkabel, die nicht gezeichnet sind, verbunden.

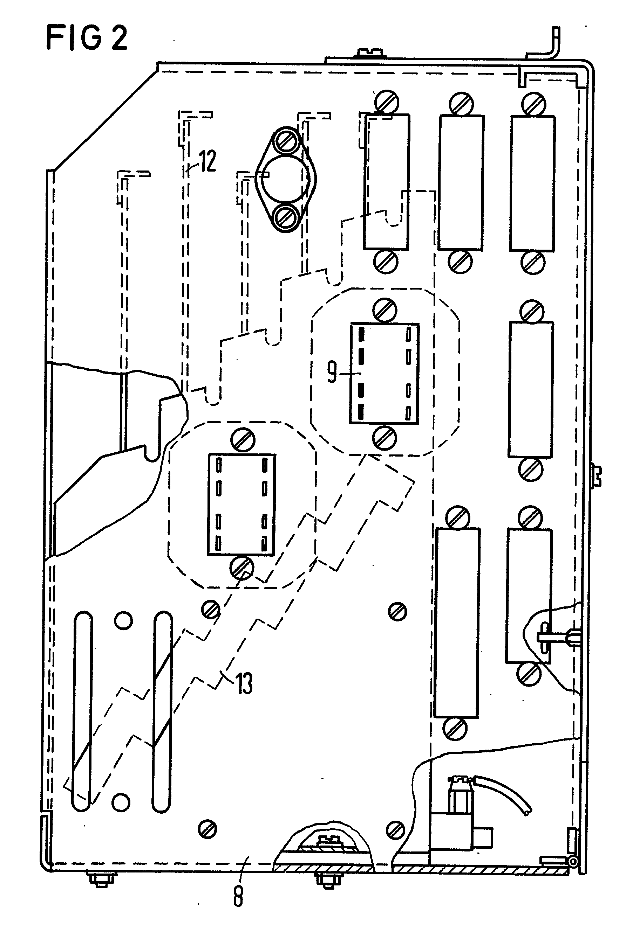

Auf den Seitenwänden des Logikgehäuses befinden sich Steckerfelder mit den Steckern 9, wie in Fig. 2 gezeigt. Auch die Leiterplatten 12 sind wieder strichliert angedeutet, ebenso die zweite Kulissenführung 13 für das Ausklappen dieser Leiterplatten.

## Ansprüche

1. Tragbares Koffergerät zur Prüfung von Datenfernverarbeitungssystemen, bei dem der zur Prüfung notwendige Logikteil (1) räumlich vom zugehörigen Stromversorgungsteil (2) getrennt und mit einem eigenem Gehäuse (7, 8, 17) versehen ist, das bis zu einem Winkel von etwa 15° gegenüber der Senkrechten mittels einer ersten Kulissenführung (4) ausklappbar ist, wobei die darin befindlichen Leiterplatten (12) mittels einer zweiten Kulissenführung (13) ebenfalls ausklappbar angeordnet sind, während der Stromversorgungsteil (2) fest im Koffer (3) hinter dem eingeklappten Logikteil in einem eigenen Gehäuse, das z. B. aus Aluminium bestehen kann, gut wärmeableitend installiert ist.

2. Tragbares Koffergerät nach Anspruch 1, dadurch gekennzeichnet, daß die Bedienfront (17) und die Rückseite (7) des Gehäuses des Logikteils abnehmbar sind.

3. Tragbares Koffergerät nach einem der vorhergehenden Ansprüche, dadurch gekennzeichnet, daß an den Seitenwänden (8) des Logikteils (1) Steckerfelder (9) für Ein- und Ausgänge von Messleitungen vorgesehen sind.

4. Tragbares Koffergerät nach Anspruch 3, dadurch gekennzeichnet, daß die Steckerfelder (9) für Ein- und Ausgang getrennt auf den gegenüberliegenden Seiten angeordnet sind.

5. Tragbares Koffergerät nach einem der vorhergehenden Ansprüche, dadurch gekennzeichnet, daß das Gehäuse des Logikteils (1) mit den zum Aufklappen notwendigen Aufstellstützen (10) durch leicht lös- und entfernbare Schrauben (11) verbunden ist.

6. Tragbares Koffergerät nach einem der vorhergehenden Ansprüche, dadurch gekennzeichnet, daß der Logikteil (1) mit seinen klappbaren Leiterplatten (12) mittels Flachkabeln über eine Steckerleiste mit einem an der Bedienfront (17) befindlichen Bedienfeld verbunden ist.

7. Tragbares Koffergerät nach einem der vorhergehenden Ansprüche, dadurch gekennzeichnet, daß im Gehäuse des Logikteils (1) eine dritte Kulissenführung vorgesehen ist, die nach Lockerung zweier weiterer Schrauben ein zusätzliches Ausklappen des Gehäuses um 30° nach vorne gegenüber der Betriebsstellung gestatten.

## Claims

1. Portable set for testing data teleprocessing systems, wherein the logic component (1) required for the test is spatially separated from the assigned current supply component (2) and provided with a separate housing (7, 8, 17) which can be swung out up to an angle of approximately 15° in relation to the vertical by means of a first connecting link guide (4), where the printed circuit boards (12) arranged therein are positioned so as to be likewise capable of being swung out by means of a second connecting link guide (13), whereas the current supply component (2) is firmly installed in the case (3) behind the swung-in logic component in a separate housing, which can consist, for example, of aluminium, so as to have a high capacity for dissipating heat.

2. Portable set as claimed in claim 1, characterised in that the control front (17) and the rear (7) of the housing of the logic component are detachable.

3. Portable set as claimed in one of the preceding claims, characterised in that on the side walls (8) of the logic component (1), there are arranged plug panels (9) for inputs and outputs of measuring lines.

4. Portable set as claimed in claim 3, characterised in that the plug panels (9) for input and output are separately arranged on the opposite sides.

5. Portable set as claimed in one of the preceding claims, characterised in that the housing of the logic component (1) is connected to the supports (10), which are required for the swinging out operation, by means of screws (11) which can be easily loosened and removed.

6. Portable set as claimed in one of the preceding claims, characterised in that the logic component (1) together with its hinged printed circuit boards (12) is connected to a control panel, which is disposed adjacent the control front (17), by means of flat cables via a plug strip.

7. Portable set as claimed in one of the preceding claims, characterised in that in the housing of the logic component (1), there is arranged a third connecting link guide which, after two further screws have been loosened, enables the housing to be additionally swung out by 30° towards the front in relation to the operating position.

## Revendications

1. Appareil portatif à mallette pour vérifier des systèmes de télétraitement de données, dans lequel la partie logique (1) qui est nécessaire pour la vérification est spatialement séparée de la partie alimentation en courant associée (2) et est pourvue d'un boîtier (7, 8, 17) qui lui est própre et

qui, au moyen d'un premier guidage à coulisse, est susceptible d'être soulevé, par pivotement jusqu'à un angle d'environ 15° par rapport à la verticale, les plaques de circuits imprimés (12) qui s'y trouvent étant également susceptibles d'être soulevées par pivotement à l'aide d'un second guidage à coulisse, alors que la partie alimentation en courant (2) est installée, de manière à bien dissiper la chaleur, en position fixe dans la mallette, derrière la partie logique rabattue, dans un boîtier qui lui est propre et qui peut être réalisé par exemple en aluminium.

2. Appareil portatif à mallette selon la revendication 1, caractérisé par le fait que la partie frontale de commande (17) et le côté arrière (7) du boîtier de la partie logique (1) sont démontables.

3. Appareil portatif à mallette selon l'une des revendications précédentes, caractérisé par le fait que sur les parois latérales (8) de la partie logique (1) sont prévus des champs à raccordement par fiches, pour des entrées et des sorties de lignes de mesure.

4. Appareil portatif à mallette selon la revendication 3, caractérisé par le fait que les champs (9), à fiches de raccordement, pour l'entrée et la sortie, sont disposés séparément sur des côtés opposés.

5. Appareil portatif à mallette selon l'une des revendications précédentes, caractérisé par le fait que le boîtier de la partie logique (1) est relié aux supports de montage (10) nécessaires pour le soulèvement par pivotement à l'aide de vis (11) faciles à dévisser et à enlever.

6. Appareil portatif à mallette suivant l'une des revendications précédentes, caractérisé par le fait que la partie logique (1), avec ses plaques à circuits imprimés basculantes (12), est reliée, à l'aide de câbles plats, par l'intermédiaire de réglettes à fiches, à un pupitre de commande qui se trouve dans la partie frontale de commande (17).

7. Appareil portatif à mallette selon l'une des revendications précédentes, caractérisé par le fait qu'il est prévu dans le boîtier de la partie logique (1) un troisième guidage à coulisse qui, après desserrage de deux autres vis, autorise un pivotement supplémentaire du boîtier, de 30° vers l'avant, par rapport à la position de service.

# FIG 1

# FIG 2